# FASCICULE DE BREVET EUROPEEN

(11) **EP 3 506 264 B1**
(45) Date de publication et mention de la délivrance du brevet: **29.01.2020**
(21) Numéro de dépôt: 18214961.7
(22) Date de dépôt: 20.12.2018
(51) Int. Cl.: G11C 7/18, G11C 5/06, G11C 5/02, G11C 7/10, G11C 11/412, G11C 11/417, G11C 11/419, H03K 19/177, G11C 8/12, G11C 11/405, G11C 11/408, G11C 11/409, G11C 11/4094, G11C 11/4096, G11C 11/4097, G11C 13/00

(54) **CIRCUIT MÉMOIRE**
SPEICHERSCHALTKREIS
MEMORY CIRCUIT

(30) Priorité: 26.12.2017 FR 1763221
(43) Date de publication de la demande: 03.07.2019
(73) Titulaire: Commissariat à l'Energie Atomique et aux Energies Alternatives, 75015 Paris (FR)
(72) Inventeur: NOEL, Jean-Philippe, 38320 EYBENS (FR); GIRAUD, Bastien, 38340 VOREPPE (FR); MAKOSIEJ, Adam, 38000 GRENOBLE (FR)
(74) Mandataire: Cabinet Beaumont

(56) Documents cités:
- US-A- 5 594 698
- US-A1- 2011 026 314
- US-A1- 2013 051 131
- US-A1- 2017 110 180
- US-A1- 2017 345 505
- US-B1- 6 452 841
- CHANG KEVIN K ET AL: "Low-Cost Inter-Linked Subarrays (LISA): Enabling fast inter-subarray data movement in DRAM", 2016 IEEE INTERNATIONAL SYMPOSIUM ON HIGH PERFORMANCE COMPUTER ARCHITECTURE (HPCA), IEEE, 12 mars 2016 (2016-03-12), pages 568-580, XP032888480, DOI: 10.1109/HPCA.2016.7446095

## Description

### Domaine

La présente demande concerne le domaine des circuits mémoires. Elle vise plus particulièrement un circuit mémoire adapté à mettre en oeuvre des opérations de calcul ayant pour opérandes des données stockées dans le circuit, et/ou à mettre en oeuvre des transferts de données entre des zones de stockage distinctes du circuit.

### Exposé de l'art antérieur

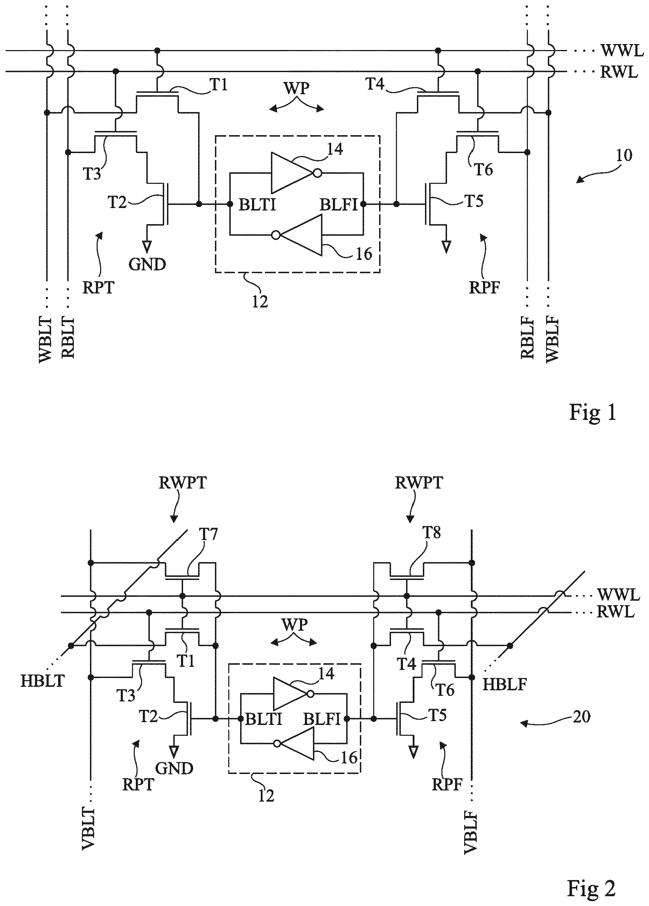

La figure 1 est un schéma électrique d'un exemple d'une cellule élémentaire 10 d'un circuit mémoire.

La cellule élémentaire 10 de la figure 1 est une cellule à dix transistors. Elle comprend une cellule de stockage SRAM 12 à quatre transistors, deux ports d'accès en lecture RPT et RPF à deux transistors chacun, et un port d'accès en écriture WP à deux transistors. La cellule de stockage 12 comprend deux inverseurs 14 et 16 (comprenant chacun deux transistors) montés en antiparallèle entre un premier noeud BLTI de stockage d'un bit de donnée, et un deuxième noeud BLFI de stockage d'un bit de donnée complémentaire du bit stocké sur le noeud BLTI. Le port d'accès en écriture WP comprend un transistor T1 reliant, par ses noeuds de conduction, le noeud BLTI à une première piste conductrice d'écriture WBLT, et un transistor T4 reliant, par ses noeuds de conduction, le noeud BLFI à une deuxième piste conductrice d'écriture WBLF. Les grilles des transistors T1 et T4 sont reliées à une piste conductrice de contrôle d'écriture WWL. Le port d'accès en lecture RPT comprend deux transistors T2 et T3 montés en série, via leurs noeuds de conduction, entre un noeud GND d'application d'un potentiel de référence de la cellule, par exemple la masse, et une première piste conductrice de lecture RBLT. Le transistor T2 est situé côté noeud GND et a sa grille reliée au noeud BLTI, et le transistor T3 est situé côté piste RBLT et a sa grille reliée à une piste conductrice de contrôle de lecture RWL. Le port d'accès en lecture RPF comprend deux transistors T5 et T6 montés en série, via leurs noeuds de conduction, entre le noeud de référence GND et une deuxième piste conductrice de lecture RBLF. Le transistor T5 est situé côté noeud GND et a sa grille reliée au noeud BLFI, et le transistor T6 est situé côté piste RBLF et a sa grille reliée à la piste conductrice de contrôle de lecture RWL.

Un circuit mémoire comprend classiquement une pluralité de cellules élémentaires 10 du type décrit en relation avec la figure 1, identiques ou similaires, agencées en matrice selon des rangées et des colonnes. Les cellules d'une même rangée sont interconnectées via leurs pistes conductrices WWL, respectivement RWL, et les cellules d'une même colonne sont interconnectées via leurs pistes conductrices RBLT, respectivement WBLT, respectivement RBLF, respectivement WBLF.

Pour réaliser une opération de lecture d'une cellule élémentaire 10 de la mémoire, les pistes conductrices de sortie RBLT et RBLF de la cellule sont préchargées à un potentiel de niveau haut, c'est à dire à un potentiel positif par rapport au potentiel de référence du noeud GND. Les transistors T3 et T6 de la cellule sont ensuite rendus passants par application d'un potentiel de niveau haut sur la piste conductrice RWL de la cellule. Après l'activation des transistors T3 et T6, la piste conductrice RBLT se décharge si le potentiel du noeud BLTI est à un niveau haut (transistor T2 passant), et reste sensiblement à son niveau de précharge si le potentiel du noeud BLTI est à un niveau bas (transistor T2 bloqué). De façon similaire, la piste conductrice RBLF se décharge si le potentiel du noeud BLFI est à un niveau haut (transistor T5 passant), et reste sensiblement à son niveau de précharge si le potentiel du noeud BLFI est à un niveau bas (transistor T5 bloqué). La lecture du potentiel de la piste RBLT et/ou de la piste RBLF via un circuit de lecture non représenté, par exemple disposé en pied de colonne, permet de déterminer la valeur du bit de donnée stocké dans la cellule élémentaire.

Pour réaliser une opération d'écriture d'une cellule élémentaire 10 de la mémoire, un potentiel de niveau haut est appliqué sur la piste conductrice d'écriture WBLT et un potentiel de niveau bas est appliqué sur la piste conductrice d'écriture WBLF, ou inversement selon la valeur du bit de donnée à écrire. Les transistors T1 et T4 de la cellule sont ensuite rendus passants par application d'un signal de niveau haut sur la piste conductrice WWL de la cellule. Les niveaux de potentiel appliqués sur les pistes conductrices WBLT et WBLF se trouvent alors mémorisés respectivement sur les noeuds de stockage BLTI et BLFI, jusqu'à la prochaine opération d'écriture.

Il a par ailleurs déjà été proposé, dans la demande de brevet européen N°17172088.1 déposée par le demandeur le 19 mai 2017 sous priorité de la demande de brevet français N°16/54623 du 24 mai 2016, un circuit mémoire adapté non seulement à stocker des données, mais aussi à effectuer, in-situ, lors d'accès au contenu de la mémoire, un certain nombre d'opérations logiques et/ou arithmétiques ayant pour opérandes des données stockées dans la mémoire. Ce circuit comprend, comme dans un circuit mémoire classique, une pluralité de cellules élémentaires, par exemple du type décrit en relation avec la figure 1, agencées en matrice selon des rangées et des colonnes, et un circuit de contrôle adapté à mettre en oeuvre des opérations de lecture ou d'écriture de données dans des rangées ou des portions de rangées de la matrice. A la différence d'un circuit mémoire classique dans lequel une seule rangée de la matrice peut être sélectionnée à la fois lors d'une opération de lecture, le circuit de contrôle est adapté à sélectionner simultanément en lecture une pluralité de rangées de la matrice de façon à réaliser une opération logique ayant pour opérandes les données contenues dans les rangées sélectionnées.

US 2013/051131 A1 divulgue une cellule mémoire SRAM à 10 transistors ayant un port d'accès en lecture et un port d'accès en lecture et écriture.

L'article scientifique CHANG KEVIN K ET AL: "Low-Cost Inter-Linked Subarrays (LISA): Enabling fast inter-subarray data movement in DRAM",2016 IEEE INTERNATIONAL SYMPOSIUM ON HIGH PERFORMANCE COMPUTER ARCHITECTURE (HPCA), IEEE, 12 mars 2016 (2016-03-12), pages 568-580, XP032888480 divulgue des cellules élémentaires qui ont les mêmes coordonnées dans des différentes matrices et qui partagent une même première piste conductrice.

Il serait souhaitable d'améliorer au moins en partie certains aspects des circuits mémoire connus.

### Résumé

L'invention est définie par l'objet de la revendication indépendante 1. D'autres réalisations préférées sont définies par l'objet des revendications dépendantes. Ainsi, un mode de réalisation prévoit un circuit mémoire comprenant une pluralité de cellules élémentaires comprenant chacune :
une cellule de stockage comprenant un premier noeud de stockage d'un bit de donnée ;
un premier port d'accès en lecture comportant un premier transistor relié par sa grille au premier noeud de stockage, et un deuxième transistor monté en série avec le premier transistor entre un premier noeud d'application d'un potentiel de référence de la cellule et une première piste conductrice de la cellule ; et
un premier port d'accès en lecture et écriture comportant un troisième transistor reliant le premier noeud de stockage de la cellule à la première piste conductrice de la cellule, la grille du deuxième transistor étant reliée à une deuxième piste conductrice de la cellule et la grille du troisième transistor étant reliée à une troisième piste conductrice de la cellule,
dans lequel les cellules élémentaires sont agencées en une pluralité de matrices comportant chacune plusieurs rangées et plusieurs colonnes, et dans lequel :
   dans chaque matrice, les cellules élémentaires d'une même rangée de la matrice partagent une même deuxième piste conductrice et une même troisième piste conductrice ; et
   les cellules élémentaires ayant les mêmes coordonnées dans les différentes matrices partagent une même première piste conductrice.

Selon un mode de réalisation, le premier port d'accès en lecture et écriture de chaque cellule élémentaire comprend en outre un quatrième transistor reliant le premier noeud de stockage à une quatrième piste conductrice de la cellule, et, dans chaque matrice, les cellules élémentaires d'une même colonne de la matrice partagent une même quatrième piste conductrice.

Selon un mode de réalisation :
dans chaque cellule élémentaire, la cellule de stockage comprend en outre un deuxième noeud de stockage d'un bit de donnée complémentaire du bit stocké sur le premier noeud de stockage ;
chaque cellule élémentaire comprend un deuxième port d'accès en lecture comportant un cinquième transistor relié par sa grille au deuxième noeud de stockage de la cellule, un sixième transistor monté en série avec le cinquième transistor entre le premier noeud d'application d'un potentiel de référence de la cellule et une cinquième piste conductrice de la cellule ;
chaque cellule élémentaire comprend un deuxième port d'accès en lecture et écriture comprenant un septième transistor reliant le deuxième noeud de stockage de la cellule à la cinquième piste conductrice de la cellule, la grille du sixième transistor étant reliée à la deuxième piste conductrice de la cellule et la grille du septième transistor étant reliée à la troisième piste conductrice de la cellule ; et
les cellules élémentaires ayant les mêmes coordonnées dans les différentes matrices partagent une même cinquième piste conductrice.

Selon un mode de réalisation, le deuxième port d'accès en lecture et écriture de chaque cellule élémentaire comprend en outre un huitième transistor reliant le deuxième noeud de stockage de la cellule à une sixième piste conductrice de la cellule, et, dans chaque matrice, les cellules élémentaires d'une même colonne de la matrice partagent une même sixième piste conductrice.

Selon un mode de réalisation, dans chaque cellule élémentaire, la cellule de stockage comprend deux inverseurs montés en antiparallèle.

Selon un mode de réalisation, les différentes matrices sont formées respectivement dans une pluralité de niveaux semiconducteurs superposés d'un circuit intégré.

Selon un mode de réalisation, dans chaque matrice, les cellules élémentaires d'une même rangée ont leurs premiers noeuds connectés à une même piste conductrice d'application d'un potentiel de référence, les cellules élémentaires de rangées distinctes ayant leurs premiers noeuds connectés à des pistes conductrices d'application d'un potentiel de référence distinctes, et les cellules élémentaires de matrices distinctes ayant leurs premiers noeuds connectés à des pistes conductrices d'application d'un potentiel de référence distinctes.

Selon un mode de réalisation, le circuit mémoire comprend en outre, pour chaque première piste conductrice, une cellule élémentaire de précharge comprenant un transistor reliant la première piste conductrice à un noeud d'application d'un potentiel d'alimentation haut du circuit.

Selon un mode de réalisation, le circuit mémoire comprend en outre, pour chaque première piste conductrice, un circuit logique élémentaire connecté à la première piste conductrice.

Selon un mode de réalisation, les circuits logiques élémentaires sont réalisés en technologie CMOS ou en technologie ReRAM.

Selon un mode de réalisation, le circuit mémoire comprend en outre un circuit de contrôle adapté à appliquer simultanément :
sur la deuxième piste conductrice d'une première rangée d'une première matrice du circuit mémoire, un signal de commande à l'état passant des deuxièmes transistors des cellules de la première rangée ; et
sur la troisième piste conductrice d'une deuxième rangée d'une deuxième matrice du circuit mémoire, les cellules de la deuxième rangée étant connectées aux mêmes premières pistes conductrices que les cellules de la première rangée, un signal de commande à l'état passant des troisièmes transistors des cellules de la deuxième rangée.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, précédemment décrite, est un schéma électrique d'un exemple d'une cellule élémentaire d'un circuit mémoire ;
la figure 2 est un schéma électrique d'un exemple d'une cellule élémentaire d'un circuit mémoire selon un mode de réalisation ;
la figure 3 est un schéma simplifié d'un exemple d'un circuit mémoire selon un mode de réalisation ;
la figure 4 illustre une variante de réalisation d'un circuit mémoire selon un mode de réalisation ;
la figure 5 est un schéma électrique d'un exemple d'une cellule de précharge d'un circuit mémoire selon un mode de réalisation ; et
la figure 6 est un schéma simplifié d'une autre variante d'un circuit mémoire selon un mode de réalisation.

### Description détaillée

De mêmes éléments ont été désignés par de mêmes références dans les différentes figures. Par souci de clarté, seuls les éléments utiles à la compréhension des modes de réalisation décrits ont été représentés et sont détaillés. En particulier, la réalisation des circuits périphériques d'entrée/sortie et/ou de contrôle des circuits mémoires décrits n'a pas été détaillée, la réalisation de tels circuits étant à la portée de l'homme du métier à partir des indications de la présente description. Dans la présente description, les références à des signaux de niveau haut et bas doivent être interprétées de façon relative, comme correspondant à deux états distincts des signaux binaires traités par les circuits décrits. A titre d'exemple, un potentiel de niveau haut correspond à un potentiel de l'ordre d'un potentiel d'alimentation haut VDD des circuits décrits (par exemple égal à VDD à 10 % près ou à VDD à 0,3 V près), et un potentiel de niveau bas correspond à un potentiel de l'ordre d'un potentiel d'alimentation bas GND des circuits décrits (par exemple égal à GND à 10 % près ou à VDD à 0,3 V près). Dans la présente description, on utilise le terme "connecté" pour désigner une liaison électrique directe, sans composant électronique intermédiaire, par exemple au moyen d'une ou plusieurs pistes conductrices, et le terme "couplé" ou le terme "relié", pour désigner une liaison qui peut être directe (signifiant alors "connecté") ou qui peut être réalisée par l'intermédiaire d'un ou plusieurs composants.

La figure 2 est un schéma électrique d'un exemple d'une cellule élémentaire 20 d'un circuit mémoire.

La cellule élémentaire 20 de la figure 2 est une cellule à douze transistors. Elle comprend des éléments en commun avec la cellule 10 de la figure 1. En particulier, la cellule 20 de la figure 2 comprend une cellule de stockage SRAM 12 à quatre transistors, identique ou similaire à la cellule 12 de la figure 1, et deux ports d'accès en lecture RPT et RPF à deux transistors chacun. La cellule 20 de la figure 2 comprend en outre deux ports d'accès en lecture/écriture RWPT et RWPF à deux transistors chacun.

Plus particulièrement, le port d'accès en lecture/écriture RWPT comprend un transistor T1 reliant, par ses noeuds de conduction, le noeud BLTI à une piste conductrice d'accès HBLT, et un transistor T7 reliant, par ses noeuds de conduction, le noeud BLTI à une piste conductrice d'accès VBLT. Les grilles des transistors T1 et T7 sont reliées à une piste conductrice de contrôle WWL. Le port d'accès en lecture RPT comprend deux transistors T2 et T3 montés en série, via leurs noeuds de conduction, entre un noeud GND d'application d'un potentiel de référence de la cellule, par exemple la masse ou un potentiel d'alimentation bas du circuit, et la piste conductrice d'accès VBLT. Le transistor T2 est situé côté noeud GND et a sa grille reliée au noeud BLTI, et le transistor T3 est situé côté piste VBLT et a sa grille reliée à une piste conductrice de contrôle RWL.

Dans l'exemple représenté, le transistor T1 a un premier noeud de conduction connecté au noeud BLTI et un deuxième noeud de conduction connecté à la piste HBLT, le transistor T2 a un premier noeud de conduction connecté au noeud GND et un deuxième noeud de conduction connecté à un premier noeud de conduction du transistor T3, le deuxième noeud de conduction du transistor T3 étant connecté à la piste VBLT, et le transistor T7 a un premier noeud de conduction connecté au noeud BLTI et un deuxième noeud de conduction connecté à la piste VBLT. De plus, dans cet exemple, les grilles des transistors T1, T2, T3 et T7 sont connectées respectivement à la piste WWL, au noeud BLTI, à la piste RWL et à la piste WWL.

Le port d'accès en lecture/écriture RWPF comprend quant à lui un transistor T4 reliant, par ses noeuds de conduction, le noeud BLFI à une piste conductrice d'accès HBLF, et un transistor T8 reliant, par ses noeuds de conduction, le noeud BLFI à une piste conductrice d'accès VBLF. Les grilles des transistors T4 et T8 sont reliées à la piste conductrice de contrôle WWL. Le port d'accès en lecture RPF comprend deux transistors T5 et T6 montés en série, via leurs noeuds de conduction, entre un noeud GND d'application d'un potentiel de référence de la cellule, par exemple la masse, et la piste conductrice d'accès VBLF. Le transistor T5 est situé côté noeud GND et a sa grille reliée au noeud BLFI, et le transistor T6 est situé côté piste VBLF et a sa grille reliée à la piste conductrice de contrôle RWL.

Dans l'exemple représenté, le transistor T4 a un premier noeud de conduction connecté au noeud BLFI et un deuxième noeud de conduction connecté à la piste HBLF, le transistor T5 a un premier noeud de conduction connecté au noeud GND et un deuxième noeud de conduction connecté à un premier noeud de conduction du transistor T6, le deuxième noeud de conduction du transistor T6 étant connecté à la piste VBLT, et le transistor T8 a un premier noeud de conduction connecté au noeud BLFI et un deuxième noeud de conduction connecté à la piste VBLF. De plus, dans cet exemple, les grilles des transistors T4, T5, T6 et T8 sont connectées respectivement à la piste WWL, au noeud BLFI, à la piste RWL et à la piste WWL.

Dans l'exemple représenté, les transistors T1, T2, T3, T4, T5, T6, T7 et T8 sont des transistors MOS à canal N, les noeuds de conduction des transistors étant leurs noeuds de source et de drain.

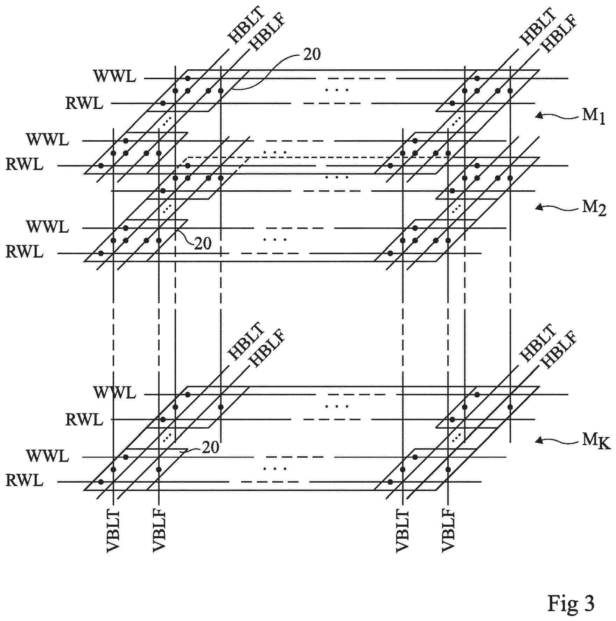

La figure 3 est un schéma simplifié d'un exemple d'un circuit mémoire selon un mode de réalisation. Le circuit mémoire de la figure 3 comprend une pluralité de cellules élémentaires 20 du type décrit en relation avec la figure 2, identiques ou similaires, agencées en K matrices M₁, ..., M_{K} de plusieurs cellules chacune, où K est un entier supérieur ou égal à 2. Dans cet exemple, les différentes matrices du circuit mémoire sont de mêmes dimensions et comprennent chacune plusieurs rangées et plusieurs colonnes de cellules élémentaires 20.

La figure 3 illustre un exemple de réalisation préférentiel dans lequel les différentes matrices M₁, ..., M_{K} du circuit mémoire sont superposées. A titre d'exemple, les K matrices M₁, ..., M_{K} sont formées respectivement dans K niveaux semiconducteurs superposés d'un circuit intégré 3D, c'est-à-dire un circuit intégré comprenant une pluralité de niveaux semiconducteurs superposés interconnectés par des vias verticaux, par exemple un circuit intégré monolithique 3D réalisé selon la technologie d'intégration 3D CoolCube™ développée par le CEA Leti (par exemple décrite dans l'article de P. Batude et al. intitulé "3D sequential intégration opportunities and technology optimization", IEEE International Interconnect Technology Conférence, 2014, pages 373-376). Les modes de réalisation décrits ne se limitent toutefois pas à cet agencement particulier des matrices M₁, ..., M_{K}.

Dans chaque matrice Mᵢ, avec i entier allant de 1 à K, les cellules d'une même rangée de la matrice sont interconnectées via leurs pistes conductrices WWL, respectivement RWL, et les cellules d'une même colonne de la matrice sont interconnectées via leurs pistes conductrices HBLT, respectivement HBLF. Autrement dit, les cellules d'une même rangée de la matrice Mᵢ partagent une même piste conductrice WWL et une même piste conductrice RWL, et les cellules d'une même colonne de la matrice Mᵢ partagent une même piste conductrice HBLT et une même piste conductrice HBLF. Les cellules de rangées distinctes d'une même matrice Mᵢ sont quant à elles connectées à des pistes conductrices WWL, respectivement RWL, distinctes, et les cellules de colonnes distinctes d'une même matrice Mᵢ sont connectées à des pistes conductrices HBLT, respectivement HBLF, distinctes. De plus, les cellules de matrices distinctes sont connectées à des pistes conductrices WWL, respectivement RWL, respectivement HBLT, respectivement HBLF, distinctes.

Dans l'exemple de la figure 3, les cellules élémentaires 20 ayant les mêmes coordonnées (c'est-à-dire le même indice de rangée et le même indice de colonne) dans les différentes matrices Mᵢ, sont interconnectées via leurs pistes conductrices VBLT, respectivement VBLF. Autrement dit, les cellules ayant les mêmes coordonnées dans les différentes matrices Mᵢ partagent une même piste conductrice VBLT et une même piste conductrice VBLF. Dans chaque matrice Mᵢ, les différentes cellules de la matrice sont quant à elles connectées à des pistes conductrices VBLT, respectivement VBLF, distinctes.

Pour réaliser une opération de lecture d'une cellule élémentaire 20 du circuit mémoire, les pistes conductrices VBLT et VBLF de la cellule sont préchargées à un potentiel de niveau haut, c'est à dire à un potentiel positif par rapport au potentiel de référence du noeud GND, puis laissées flottantes. Les transistors T3 et T6 de la cellule sont ensuite rendus passants par application d'un potentiel de niveau haut sur la piste conductrice RWL de la cellule. Les transistors T1, T7, T4 et T8 sont quant à eux maintenus bloqués par application d'un potentiel de niveau bas sur la piste conductrice WWL de la cellule. Après l'activation des transistors T3 et T6, la piste conductrice VBLT se décharge si le potentiel du noeud BLTI est à un niveau haut (transistor T2 passant), et reste sensiblement à son niveau de précharge si le potentiel du noeud BLTI est à un niveau bas (transistor T2 bloqué). De façon similaire, la piste conductrice VBLF se décharge si le potentiel du noeud BLFI est à un niveau haut (transistor T5 passant), et reste sensiblement à son niveau de précharge si le potentiel du noeud BLFI est à un niveau bas (transistor T5 bloqué). La lecture du potentiel de la piste VBLT et/ou de la piste VBLF via un circuit de lecture non représenté, permet de déterminer la valeur du bit de donnée stocké dans la cellule élémentaire.

Pour réaliser une opération d'écriture d'une cellule élémentaire 20 de la mémoire, un potentiel de niveau haut est appliqué sur la piste conductrice VBLT, et un potentiel de niveau bas est appliqué sur la piste conductrice VBLF, ou inversement selon la valeur du bit de donnée à écrire. Les pistes conductrices HBLT et HBLF peuvent quant à elles être maintenues à un potentiel de niveau haut. Les transistors T1, T7, T4 et T8 de la cellule sont ensuite rendus passants par application d'un signal de niveau haut sur la piste conductrice WWL de la cellule. Les niveaux de potentiel appliqués sur les pistes conductrices VBLT d'une part, et VBLF d'autre part, se trouvent alors mémorisés respectivement sur les noeuds de stockage BLTI et BLFI, jusqu'à la prochaine opération d'écriture.

De façon alternative, les opérations de lecture ou d'écriture peuvent être mises en oeuvre par l'intermédiaire des pistes conductrices HBLT et HBLF, sans passer par les pistes conductrice VBLT et VBLF.

Le circuit mémoire de la figure 3 permet en outre de réaliser aisément des opérations de transfert de données entre des matrices distinctes du circuit.

A titre d'exemple, le circuit mémoire de la figure 3 permet de réaliser une opération de copie ou transfert du contenu d'une rangée d'une matrice Mᵢ de la mémoire, appelée ici rangée source, dans une rangée de même indice d'une matrice Mⱼ de la mémoire, appelée ici rangée destination, où j est un entier compris dans la plage allant de 1 à K, avec i différent de j.

Pour réaliser une telle opération de transfert, les pistes conductrices VBLT et VBLF des cellules des rangées source et destination sont préchargées à un potentiel de niveau haut, puis laissées flottantes. Les transistors T3 et T6 des cellules de la rangée source sont ensuite rendus passants par application d'un potentiel de niveau haut sur la piste conductrice RWL de la rangée. Les transistors T1, T7, T4 et T8 des cellules de la rangée source sont quant à eux maintenus bloqués par application d'un potentiel de niveau bas sur la piste conductrice WWL de la rangée. De plus, les transistors T1, T7, T4 et T8 des cellules de la rangée destination sont rendus passants par application d'un potentiel de niveau haut sur la piste conductrice WWL de la rangée. Les transistors T3 et T6 des cellules de la rangée destination sont quant à eux maintenus bloqués par application d'un potentiel de niveau bas sur la piste conductrice RWL de la rangée. Pendant l'opération de transfert, les pistes conductrices HBLT et HBLF des cellules de la rangée destination sont maintenues à un potentiel de niveau haut.

A titre d'exemple, pendant l'opération de transfert, les pistes conductrices RWL et WWL des autres rangées de la matrice source Mᵢ et les pistes conductrices RWL et WWL des autres rangées de la matrice destination Mⱼ sont maintenues à un potentiel de niveau bas. Les pistes conductrices HBLT et HBLF des cellules de la rangée source peuvent quant à elles être maintenues à un potentiel de niveau haut. Le cas échéant, les pistes conductrices RWL et WWL des rangées des autres matrices du circuit mémoire peuvent être maintenues à un potentiel de niveau bas, et les pistes conductrices HBLT et HBLF des cellules des autres matrices du circuit mémoire peuvent quant à elles être maintenues à un potentiel de niveau haut.

Pour chaque cellule de la rangée source, la piste conductrice VBLT connectée à la cellule se décharge si le potentiel du noeud BLTI est à un niveau haut (transistor T2 passant), et reste sensiblement à son niveau de précharge si le potentiel du noeud BLTI est à un niveau bas (transistor T2 bloqué) . De façon similaire, la piste conductrice VBLF connectée à la cellule se décharge si le potentiel du noeud BLFI est à un niveau haut (transistor T5 passant), et reste sensiblement à son niveau de précharge si le potentiel du noeud BLFI est à un niveau bas (transistor T5 bloqué). Dans la cellule correspondante de la rangée destination, c'est-à-dire dans la cellule de la rangée destination connectée aux mêmes pistes conductrices VBLT et VBLF, les transistors T7 et T8 étant passants, les niveaux de potentiel appliqués sur les pistes conductrices VBLT et VBLF sont mémorisés respectivement sur les noeuds de stockage BLTI et BLFI de la cellule. Ainsi, le contenu de chaque cellule de la rangée source est recopié dans la cellule correspondante de la rangée destination. Le maintien à un même potentiel de niveau haut des pistes conductrices HBLT et HBLF de chaque cellule de la rangée destination a pour effet que la mise à l'état passant des transistors T1 et T4 ne perturbe pas la copie des données de la rangée source dans la rangée destination.

On notera que de façon similaire, le contenu d'une rangée source peut être copié simultanément dans plusieurs rangées destination de matrices distinctes du circuit mémoire, partageant les mêmes pistes conductrices VBLT et VBLF. En outre, plusieurs rangées source d'indices distincts, appartenant à une même matrice source ou à des matrices sources distinctes, peuvent être copiées simultanément dans des rangées destination correspondantes d'une même matrice destination ou de plusieurs matrices destination.

Ainsi, un circuit mémoire du type décrit en relation avec la figure 3 permet de réaliser des opérations de transfert direct de données entre des matrices Mᵢ distinctes du circuit, sans passer par des circuits périphériques d'entrée/sortie du circuit.

Le circuit mémoire de la figure 3 permet en outre de réaliser aisément des opérations de calcul entre des données appartenant à des matrices distinctes du circuit.

A titre d'exemple, le circuit mémoire de la figure 3 permet de réaliser une opération de calcul logique entre le contenu d'une rangée d'une première matrice Mᵢ, appelée ici première rangée opérande, et le contenu d'une rangée de même indice d'une deuxième matrice Mᵢ, (avec i' entier allant de 1 à K et i' différent de i), appelée ici deuxième rangée opérande, et d'écrire le résultat de l'opération dans une rangée de même indice d'une troisième matrice Mⱼ, appelée ici rangée destination.

Pour réaliser une telle opération de calcul, le circuit mémoire est par exemple commandé de façon similaire à ce qui a été décrit ci-dessus pour la mise en oeuvre d'une opération de copie du contenu d'une rangée source dans une rangée destination, à ceci près que, cette fois, deux rangées sources correspondant respectivement aux première et deuxième rangées opérandes sont activées simultanément en lecture par application d'un potentiel de niveau haut sur leurs pistes conductrices RWL respectives.

Ainsi, un circuit mémoire du type décrit en relation avec la figure 3 permet de réaliser des opérations de calcul ayant pour opérandes des données mémorisées dans le circuit, et de réécrire directement le résultat des opérations dans le circuit sans passer par des circuits périphériques d'entrée/sortie du circuit.

Le circuit mémoire peut comporter un circuit de contrôle, non représenté, adapté à mettre en oeuvre les diverses opérations décrites ci-dessus.

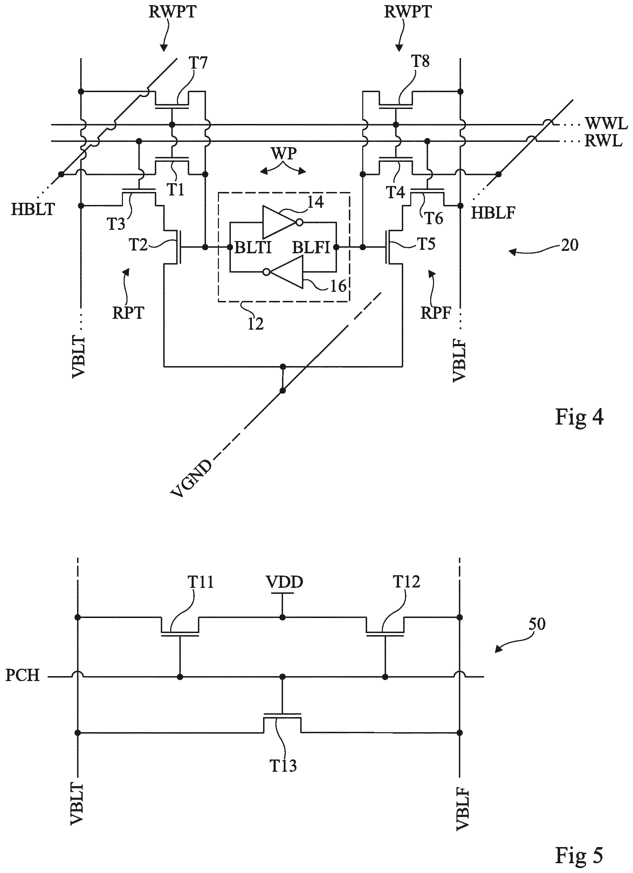

La figure 4 illustre une variante de réalisation d'un circuit mémoire du type décrit en relation avec les figures 2 et 3. Sur la figure 4, une unique cellule élémentaire 20 du circuit a été représentée. La cellule 20 de la figure 4 comprend les mêmes éléments que la cellule 20 de la figure 2, agencés sensiblement de la même manière. Le circuit mémoire de la figure 4 diffère du circuit mémoire de la figure 3 en ce que, dans l'exemple de la figure 4, le noeud de conduction du transistor T2 opposé au transistor T3 et le noeud de conduction du transistor T5 opposé au transistor T6 sont connectés non pas au noeud de référence GND directement, mais à une piste conductrice VGND, ou masse virtuelle.

Dans cet exemple, dans chaque matrice Mᵢ du circuit mémoire, les cellules d'une même colonne de la matrice sont interconnectées via leurs pistes conductrices VGND. Autrement dit, les cellules d'une même colonne de la matrice Mᵢ partagent une même piste conductrice VGND. Les cellules de colonnes distinctes d'une même matrice Mᵢ sont quant à elles connectées à des pistes conductrices VGND distinctes. De plus, les cellules de matrices distinctes du circuit mémoire sont connectées à des pistes conductrices VGND distinctes.

Le circuit mémoire de la figure 4 permet de réaliser sensiblement les mêmes opérations que ce qui a été décrit précédemment en relation avec la figure 3. Pour cela, dans chaque colonne de chaque matrice Mᵢ du circuit mémoire, la piste conductrice VGND de la colonne est maintenue à un potentiel de niveau bas, par exemple au potentiel du noeud de référence GND (non visible sur la figure 4) du circuit.

Le circuit mémoire de la figure 4 permet en outre de réaliser une opération de copie partielle d'une rangée source d'une matrice Mᵢ vers une rangée destination d'une matrice Mⱼ. L'opération de copie partielle est similaire à l'opération de copie complète décrite en relation avec la figure 3, à ceci près que, dans l'exemple de la figure 4, les pistes conductrices VGND des cellules de la rangée source dont on ne souhaite pas copier le contenu dans la rangée destination sont maintenues à un potentiel de niveau haut. Ceci permet, pour chacune de ces cellules, et quelle que soit la valeur du bit stocké dans la cellule, d'empêcher la décharge des pistes conductrices VBLT et VBLF de la cellule, qui restent ainsi toutes deux à un état haut. Ceci permet de ne pas écraser la valeur stockée dans la cellule correspondante de la rangée destination. En effet, pour modifier la valeur mémorisée dans une cellule de la rangée destination, il convient que les niveaux de potentiel appliqués sur les noeuds BLTI et BLFI de la cellule soient différents.

De façon similaire, le circuit de la figure 4 permet de réaliser une opération de calcul logique entre le contenu d'une portion d'une première rangée opérande d'une matrice Mᵢ et le contenu d'une portion correspondante d'une deuxième rangée opérande d'une matrice M_{i'}, et d'écrire le résultat de l'opération dans une portion correspondante d'une rangée destination d'une matrice Mⱼ.

On notera par ailleurs que dans le circuit mémoire de la figure 4, les pistes conductrices VGND des cellules non concernées par les opérations mises en oeuvre dans le circuit peuvent être maintenues à un potentiel de niveau haut, ce qui permet de limiter les courants de fuite à travers les différents transistors de ces cellules.

A titre de variante, les cellules élémentaires 20 ayant les mêmes coordonnées dans les différentes matrices Mᵢ, sont interconnectées via leurs pistes conductrices VGND. Autrement dit, les cellules ayant les mêmes coordonnées dans les différentes matrices Mᵢ partagent une même piste conductrice VGND. Dans chaque matrice Mᵢ, les différentes cellules de la matrice sont quant à elles connectées à des pistes conductrices VGND distinctes.

La figure 5 est un schéma électrique d'un exemple d'une cellule de précharge 50 d'un circuit mémoire selon un mode de réalisation.

On considère ici un circuit mémoire du type décrit en relation avec les figures 3 ou 4. Pour chaque chaine de cellules élémentaires 20 interconnectées par une même piste conductrice VBLF et par une même piste conductrice VBLT, une cellule élémentaire de précharge 50 connectée aux pistes conductrices VBLT et VBLF de la chaine peut être prévue. A titre d'exemple, les cellules élémentaires de précharge 50 sont disposées selon une matrice de mêmes dimensions (même nombre de rangées et de colonnes) que les matrices Mᵢ du circuit mémoire. Dans le cas d'une implémentation 3D telle que représentée en figure 3, la matrice de cellules élémentaires de précharge est par exemple réalisée dans un niveau semiconducteur différent des niveaux semiconducteurs dans lesquels sont réalisées les différentes matrices Mᵢ du circuit mémoire.

Sur la figure 5, une unique cellule de précharge 50 a été représentée. La cellule 50 comprend deux transistors T11 et T12 reliant respectivement, par leurs noeuds de conduction, la piste conductrice VBLT à un noeud ou rail VDD d'application d'un potentiel d'alimentation haut du circuit, et la piste conductrice VBLF au noeud VDD. Plus particulièrement, le transistor T11 a un premier noeud de conduction relié, par exemple connecté, à la piste VBLT et un deuxième noeud de conduction relié, par exemple connecté, au noeud VDD, et le transistor T12 a un premier noeud de conduction relié, par exemple connecté, à la piste VBLF et un deuxième noeud de conduction relié, par exemple connecté, au noeud VDD. Les grilles des transistors T11 et T12 sont connectées à une même piste conductrice de commande PCH de la cellule. La cellule 50 de la figure 5 comprend en outre un transistor T13 reliant, par ses noeuds de conduction, la piste VBLT à la piste VBLF. Plus particulièrement, le transistor T13 a un premier noeud de conduction relié, par exemple connecté, à la piste VBLT, et un deuxième noeud de conduction relié, par exemple connecté, à la piste VBLF. La grille du transistor T13 est connectée à la piste conductrice de commande PCH de la cellule. Dans l'exemple représenté, les transistors T11, T12 et T13 sont des transistors MOS à canal N.

La cellule 50 permet de précharger les pistes conductrices VBLT et VBLF à un potentiel de niveau haut (sensiblement égal au potentiel d'alimentation haut appliqué sur le noeud VDD), notamment pour la mise en oeuvre d'opérations de lecture, de calcul ou de copie dans le circuit mémoire. Pour cela, un potentiel de niveau haut est appliqué sur la piste conductrice PCH, de façon à rendre passants les transistors T11, T12 et T13. Les pistes VBLT et VBLF se chargent alors à un potentiel sensiblement égal à celui du noeud VDD. Le transistor T13 (optionnel) permet d'équilibrer la charge des pistes VBLT et VBLF. Une fois la précharge terminée, l'opération de lecture, de calcul ou de copie proprement dite peut être mise en oeuvre.

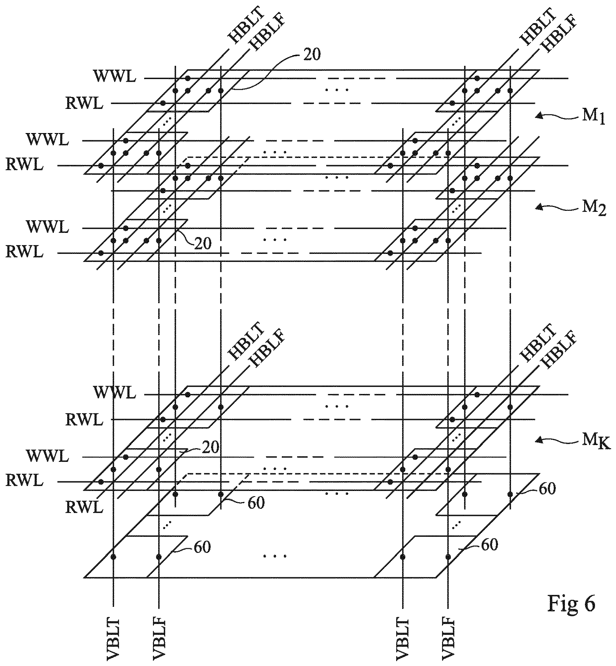

La figure 6 est un schéma simplifié d'une autre variante d'un circuit mémoire selon un mode de réalisation.

On considère ici un circuit mémoire du type décrit en relation avec la figure 3 ou 4. Pour chaque chaine de cellules élémentaires 20 interconnectées par une même piste conductrice VBLF et par une même piste conductrice VBLT, le circuit mémoire comprend en outre un circuit logique élémentaire 60 comportant une ou plusieurs portes logiques (non détaillées sur la figure), connecté au pistes conductrices VBLT et VBLF de la chaine. Chaque circuit logique élémentaire 60 est par exemple un circuit logique identique ou similaire au circuit logique élémentaire 500 décrit en relation avec les figures 5, 6 et 7 de la demande de brevet européen N°17172088.1 susmentionnée, dont le contenu est considéré comme faisant partie intégrante de la présente description. Un tel circuit logique permet notamment de réaliser des opérations de calcul supplémentaires, et notamment des opérations arithmétiques, ayant pour opérandes des données stockées dans la mémoire. A titre d'exemple, les circuits logiques élémentaires 60 sont disposés selon une matrice de mêmes dimensions (même nombre de rangées et de colonnes) que les matrices Mᵢ du circuit mémoire. Dans le cas d'une implémentation 3D telle que représentée en figure 3, la matrice de circuits logiques élémentaires est par exemple réalisée dans un niveau semiconducteur différent des niveaux semiconducteurs dans lesquels sont réalisées les différentes matrices Mᵢ du circuit mémoire.

Plus généralement, dans un circuit mémoire du type décrit en relation avec la figure 3, un ou plusieurs étages ou niveaux fonctionnels supplémentaires peuvent être prévus, ce ou ces étages supplémentaires pouvant être réalisés dans la même technologie que les étages dans lesquels sont formées les matrices Mᵢ du circuit mémoire, par exemple en technologie CMOS, ou dans une autre technologie, par exemple en technologie ReRAM (de l'anglais resistive random access memory), c'est-à-dire comprenant des cellules à résistance programmable non volatiles.

Des modes de réalisation particuliers ont été décrits. Diverses variantes et modifications apparaîtront à l'homme de l'art. En particulier, on notera que bien que, dans les exemples représentés, les transistors de contrôle des cellules élémentaires 20 (les transistors T1, T2, T3, T4, T5, T6, T7 et T8) sont des transistors MOS à canal N, les modes de réalisation décrits ne se limitent pas à ce cas particulier. A titre de variante, tous ou certains des transistors de contrôle peuvent être remplacés par des transistors MOS à canal P. L'homme du métier saura alors adapter les signaux de commande appliqués aux cellules pour obtenir le fonctionnement recherché.

Par ailleurs, on notera que dans les exemples décrits ci-dessus, les pistes conductrices HBLT et HBLF et les transistors T1 et T4 des cellules élémentaires 20 permettent de mettre en oeuvre des opérations de lecture et/ou d'écriture directement dans la matrice Mᵢ correspondante, sans passer par les pistes conductrices VBLT et VBLF. Pour certaines applications, les pistes conductrices HBLT et HBLF et les transistors T1 et T4 peuvent toutefois être omis.

De plus, dans les exemples décrits ci-dessus, les cellules élémentaires 20 sont des cellules de type différentiel, c'est-à-dire comportant deux ports d'accès en lecture RPT et RPF et deux ports d'accès en lecture/écriture RWPT et RWPF, permettant d'accéder en parallèle à deux noeuds de stockage complémentaires BLTI et BLFI de la cellule. L'homme du métier saura toutefois adapter les modes de réalisation décrits à des cellules non différentielles, c'est-à-dire comportant un unique noeud de stockage, un unique port d'accès en lecture, et un unique port d'accès en lecture/écriture.

En outre, les modes de réalisation décrits ne se limitent pas aux exemples décrits ci-dessus dans lesquels les cellules élémentaires du circuit mémoire sont des cellules de type SRAM. Plus généralement, les modes de réalisation décrits peuvent s'appliquer à d'autres technologies de cellules, par exemple des cellules de type ReRAM (mémoire résistive non volatile) ou des cellules de type DRAM (mémoire dynamique capacitive).

A titre d'exemple, pour réaliser un circuit mémoire de type ReRAM, on peut prévoir, dans les cellules 12 (figures 1, 2 et 4) des exemples décrits ci-dessus, de remplacer l'association en antiparallèle de deux inverseurs par une association en série de deux éléments résistifs à résistance programmable, une première extrémité de ladite association en série étant reliée à un noeud d'application d'un potentiel d'alimentation haut de la cellule, la deuxième extrémité de ladite association en série étant reliée à un noeud d'application d'un potentiel d'alimentation bas de la cellule, et le noeud intermédiaire de ladite association en série, ou point milieu entre les deux éléments résistifs, formant le noeud de stockage BLTI de la cellule.

A titre de variante, pour réaliser un circuit mémoire de type DRAM, on peut prévoir, dans les cellules 12 (figures 1, 2 et 4) des exemples décrits ci-dessus, de remplacer l'association en antiparallèle de deux inverseurs par un élément capacitif ayant une première électrode reliée, par exemple connectée, au noeud BLTI, et une deuxième électrode reliée, par exemple connectée, à un noeud d'application d'un potentiel de référence de la cellule.

## Revendications

1. Circuit mémoire comprenant une pluralité de cellules élémentaires (20) comprenant chacune :
une cellule de stockage (12) comprenant un premier noeud de stockage (BLTI) d'un bit de donnée ;
un premier port d'accès en lecture (RPT) comportant un premier transistor (T2) relié par sa grille au premier noeud de stockage (BLTI), et un deuxième transistor (T3) monté en série avec le premier transistor (T2) entre un premier noeud (GND) d'application d'un potentiel de référence de la cellule et une première piste conductrice (VBLT) de la cellule ; et
un premier port d'accès en lecture et écriture (RWPT) comportant un troisième transistor (T7) reliant le premier noeud de stockage (BLTI) de la cellule à la première piste conductrice (VBLT) de la cellule, la grille du deuxième transistor (T3) étant reliée à une deuxième piste conductrice (RWL) de la cellule et la grille du troisième transistor (T7) étant reliée à une troisième piste conductrice (WWL) de la cellule,
dans lequel les cellules élémentaires (20) sont agencées en une pluralité de matrices (Mᵢ) comportant chacune plusieurs rangées et plusieurs colonnes, dans lequel :
dans chaque matrice (Mᵢ), les cellules élémentaires (20) d'une même rangée de la matrice partagent une même deuxième piste conductrice (RWL) et une même troisième piste conductrice (WWL) ; et
les cellules élémentaires (20) ayant les mêmes coordonnées dans les différentes matrices (Mᵢ) partagent une même première piste conductrice (VBLT),
et dans lequel les différentes matrices (Mᵢ) sont formées respectivement dans une pluralité de niveaux semiconducteurs superposés d'un circuit intégré.

2. Circuit mémoire selon la revendication 1, dans lequel le premier port d'accès en lecture et écriture (RWPT) de chaque cellule élémentaire (20) comprend en outre un quatrième transistor (T1) reliant le premier noeud de stockage (BLTI) à une quatrième piste conductrice (HBLT) de la cellule, et dans lequel, dans chaque matrice (Mᵢ), les cellules élémentaires (20) d'une même colonne de la matrice partagent une même quatrième piste conductrice (HBLT).

3. Circuit mémoire selon la revendication 1 ou 2, dans lequel :
dans chaque cellule élémentaire (20), la cellule de stockage (12) comprend en outre un deuxième noeud de stockage (BLFI) d'un bit de donnée complémentaire du bit stocké sur le premier noeud de stockage (BLFI) ;
chaque cellule élémentaire (20) comprend un deuxième port d'accès en lecture (RPF) comportant un cinquième transistor (T5) relié par sa grille au deuxième noeud de stockage (BLFI) de la cellule, un sixième transistor (T6) monté en série avec le cinquième transistor (T5) entre le premier noeud (GND) d'application d'un potentiel de référence de la cellule et une cinquième piste conductrice (VBLF) de la cellule ;
chaque cellule élémentaire (20) comprend un deuxième port d'accès en lecture et écriture (RWPF) comprenant un septième transistor (T8) reliant le deuxième noeud de stockage (BLFI) de la cellule à la cinquième piste conductrice (VBLF) de la cellule, la grille du sixième transistor (T6) étant reliée à la deuxième piste conductrice (RWL) de la cellule et la grille du septième transistor (T8) étant reliée à la troisième piste conductrice (WWL) de la cellule ; et
les cellules élémentaires (20) ayant les mêmes coordonnées dans les différentes matrices (Mᵢ) partagent une même cinquième piste conductrice (VBLF).

4. Circuit mémoire selon la revendication 3, dans lequel le deuxième port d'accès en lecture et écriture (RWPF) de chaque cellule élémentaire (20) comprend en outre un huitième transistor (T4) reliant le deuxième noeud de stockage (BLFI) de la cellule à une sixième piste conductrice (HBLF) de la cellule, et dans lequel, dans chaque matrice (Mᵢ), les cellules élémentaires (20) d'une même colonne de la matrice partagent une même sixième piste conductrice (HBLT).

5. Circuit mémoire selon l'une quelconque des revendications 1 à 4, dans lequel, dans chaque cellule élémentaire (20), la cellule de stockage (12) comprend deux inverseurs montés en antiparallèle.

6. Circuit mémoire selon l'une quelconque des revendications 1 à 5, dans lequel, dans chaque matrice (Mᵢ), les cellules élémentaires (20) d'une même rangée ont leurs premiers noeuds (GND) connectés à une même piste conductrice (VGND) d'application d'un potentiel de référence, les cellules élémentaires (20) de rangées distinctes ayant leurs premiers noeuds (GND) connectés à des pistes conductrices (VGND) d'application d'un potentiel de référence distinctes, et les cellules élémentaires (20) de matrices (Mᵢ) distinctes ayant leurs premiers noeuds (GND) connectés à des pistes conductrices (VGND) d'application d'un potentiel de référence distinctes.

7. Circuit mémoire selon l'une quelconque des revendications 1 à 6, comprenant en outre, pour chaque première piste conductrice (VBLT), une cellule élémentaire de précharge (50) comprenant un transistor (T11) reliant la première piste conductrice (VBLT) à un noeud (VDD) d'application d'un potentiel d'alimentation haut du circuit.

8. Circuit mémoire selon l'une quelconque des revendications 1 à 7, comprenant en outre, pour chaque première piste conductrice (VBLT), un circuit logique élémentaire (60) connecté à la première piste conductrice (VBLT), le circuit logique élémentaire (60) étant adapté à mettre en oeuvre des opérations de calcul ayant pour opérandes des données stockées dans le circuit mémoire.

9. Circuit mémoire selon la revendication 8, dans lequel les circuits logiques élémentaires (60) sont réalisés en technologie CMOS ou en technologie ReRAM.

10. Circuit mémoire selon l'une quelconque des revendications 1 à 9, comprenant en outre un circuit de contrôle adapté à appliquer simultanément :
sur la deuxième piste conductrice (RWL) d'une première rangée d'une première matrice (Mᵢ) du circuit mémoire, un signal de commande à l'état passant des deuxièmes transistors (T3) des cellules de la première rangée ; et
sur la troisième piste conductrice (WWL) d'une deuxième rangée d'une deuxième matrice (Mⱼ) du circuit mémoire, les cellules de la deuxième rangée étant connectées aux mêmes premières pistes conductrices (VBLT) que les cellules de la première rangée, un signal de commande à l'état passant des troisièmes transistors (T7) des cellules de la deuxième rangée.

## Patentansprüche

1. Speicherschaltung mit einer Vielzahl von Elementarzellen (20), die jeweils folgendes aufweisen:
eine Speicherzelle (12), die einen ersten Datenbit-Speicherknoten (BLTI) aufweist;
einen ersten Lesezugriffsport (RPT), der einen ersten Transistor (T2), der durch sein Gate mit dem ersten Speicherknoten (BLTI) gekoppelt ist, und einen zweiten Transistor (T3) aufweist, der mit dem ersten Transistor (T2) zwischen einem ersten Knoten (GND) zum Anlegen eines Bezugspotentials der Zelle und einer ersten Leiterbahn (VBLT) der Zelle in Reihe angeordnet ist; und
einen ersten Lese- und Schreibzugriffsport (RWPT), der einen dritten Transistor (T7), der den ersten Speicherknoten (BLTI) der Zelle mit der ersten Leiterbahn (VBLT) der Zelle koppelt, aufweist, wobei das Gate des zweiten Transistors (T3) mit einer zweiten Leiterbahn (RWL) der Zelle und das Gate des dritten Transistors (T7) mit einer dritten Leiterbahn (WWL) der Zelle gekoppelt ist,
wobei die Elementarzellen (20) in einer Vielzahl von Anordnungen (Mᵢ) angeordnet sind, die jeweils eine Vielzahl von Zeilen und eine Vielzahl von Spalten aufweisen, wobei:
in jeder Anordnung (Mᵢ) die Elementarzellen (20) einer gleichen Reihe der Anordnung eine gleiche zweite Leiterbahn (RWL) und eine gleiche dritte Leiterbahn (WWL) teilen; und
die Elementarzellen (20) mit den gleichen Koordinaten in den verschiedenen Anordnungen (Mᵢ) sich eine gleiche erste Leiterbahn (VBLT) teilen,
und wobei die verschiedenen Anordnungen (Mᵢ) jeweils in einer Vielzahl von gestapelten Halbleiterebenen einer integrierten Schaltung ausgebildet sind.

2. Speicherschaltung nach Anspruch 1, wobei der erste Lese- und Schreibzugriffsport (RWPT) jeder Elementarzelle (20) ferner einen vierten Transistor (T1) aufweist, der den ersten Speicherknoten (BLTI) mit einer vierten Leiterbahn (HBLT) der Zelle koppelt, und wobei in jeder Anordnung (Mᵢ) die Elementarzellen (20) einer gleichen Spalte der Anordnung eine gleiche vierte Leiterbahn (HBLT) teilen.

3. Die Speicherschaltung nach Anspruch 1 oder 2, wobei:
in jeder Elementarzelle (20) die Speicherzelle (12) ferner einen zweiten Knoten (BLFI) zum Speichern eines Datenbits aufweist, das zu dem auf dem ersten Speicherknoten (BLFI) gespeicherten Bit komplementär ist;
jede Elementarzelle (20) einen zweiten Lesezugriffsport (RPF) aufweist, der einen fünften Transistor (T5) aufweist, der über sein Gate mit dem zweiten Speicherknoten (BLFI) der Zelle gekoppelt ist, einen sechsten Transistor (T6), der mit dem fünften Transistor (T5) zwischen dem ersten Knoten (GND) zum Anlegen eines Referenzpotentials der Zelle und einer fünften Leiterbahn (VBLF) der Zelle in Reihe angeordnet ist;
jede Elementarzelle (20) einen zweiten Lese- und Schreibzugriffsport (RWPF) aufweist, der einen siebten Transistor (T8) aufweist, der den zweiten Speicherknoten (BLFI) der Zelle mit der fünften Leiterbahn (VBLF) der Zelle koppelt, wobei das Gate des sechsten Transistors (T6) mit der zweiten Leiterbahn (RWL) der Zelle gekoppelt ist und das Gate des siebten Transistors (T8) mit der dritten Leiterbahn (WWL) der Zelle gekoppelt ist; und
sich die Elementarzellen (20) mit den gleichen Koordinaten in den verschiedenen Anordnungen (Mᵢ) eine gleiche fünfte Leiterbahn (VBLF) teilen.

4. Speicherschaltung nach Anspruch 3, wobei der zweite Lese- und Schreibzugriffsport (RWPF) jeder Elementarzelle (20) ferner einen achten Transistor (T4) aufweist, der den zweiten Speicherknoten (BLFI) der Zelle mit einer sechsten Leiterbahn (HBLF) der Zelle koppelt, und wobei in jeder Anordnung (Mᵢ) die Elementarzellen (20) einer gleichen Spalte der Anordnung eine gleiche sechste Leiterbahn (HBLT) teilen.

5. Speicherschaltung nach einem der Ansprüche 1 bis 4, wobei die Speicherzelle (12) in jeder Elementarzelle (20) zwei antiparallel angeordnete Inverter aufweist.

6. Speicherschaltung nach einem der Ansprüche 1 bis 5, wobei in jeder Anordnung (Mᵢ) die Elementarzellen (20) einer gleichen Reihe ihre ersten Knoten (GND) mit einer gleichen Leiterbahn (VGND) zum Anlegen eines Bezugspotentials verbunden haben, wobei die Elementarzellen (20) verschiedener Reihen ihre ersten Knoten (GND) mit unterschiedlichen Leiterbahnen (VGND) zum Anlegen eines Bezugspotentials verbunden haben und die Elementarzellen (20) verschiedener Anordnungen (Mᵢ) ihre ersten Knoten (GND) mit unterschiedlichen Leiterbahnen (VGND) zum Anlegen eines Bezugspotentials verbunden haben.

7. Speicherschaltung nach einem der Ansprüche 1 bis 6, die ferner für jede erste Leiterbahn (VBLT) eine elementare Vorladezelle (50) aufweist, die einen Transistor (T11) aufweist, der die erste Leiterbahn (VBLT) mit einem Knoten (VDD) zum Anlegen eines hohen Versorgungspotentials der Schaltung koppelt.

8. Speicherschaltung nach einem der Ansprüche 1 bis 7, die ferner für jede erste Leiterbahn (VBLT) eine elementare Logikschaltung (60) aufweist, die mit der ersten Leiterbahn (VBLT) verbunden ist, wobei die elementare Logikschaltung (60) geeignet ist, Berechnungsoperationen durchzuführen, die als Operanden in der Speicherschaltung gespeicherte Daten aufweisen.

9. Speicherschaltung nach Anspruch 8, wobei die elementaren Logikschaltungen (60) in CMOS-Technologie oder in ReRAM-Technologie ausgebildet sind.

10. Speicherschaltung nach einem der Ansprüche 1 bis 9, die ferner eine Steuerschaltung aufweist, die geeignet ist folgendes gleichzeitig anzulegen:
an der zweiten Leiterbahn (RWL) einer ersten Reihe einer ersten Anordnung (Mᵢ) der Speicherschaltung ein Signal zum Steuern der zweiten Transistoren (T3) der Zellen der ersten Reihe in den eingeschalteten Zustand; und
an der dritten Leiterbahn (WWL) einer zweiten Reihe einer zweiten Anordnung (Mⱼ) der Speicherschaltung, wobei die Zellen der zweiten Reihe mit den gleichen ersten Leiterbahnen (VBLT) verbunden sind wie die Zellen der ersten Reihe, ein Signal zum Steuern der dritten Transistoren (T7) der zweiten Reihe in den eingeschalteten Zustand.

## Claims

1. A memory circuit comprising a plurality of elementary cells (20), each comprising:
a storage cell (12) comprising a first data bit storage node (BLTI);
a first read access port (RPT) comprising a first transistor (T2) coupled by its gate to the first storage node (BLTI), and a second transistor (T3) series-assembled with the first transistor (T2) between a first node (GND) of application of a reference potential of the cell and a first conductive track (VBLT) of the cell; and
a first read and write access port (RWPT) comprising a third transistor (T7) coupling the first storage node (BLTI) of the cell to the first conductive track (VBLT) of the cell, the gate of the second transistor (T3) being coupled to a second conductive track (RWL) of the cell and the gate of the third transistor (T7) being coupled to a third conductive track (WWL) of the cell,
wherein the elementary cells (20) are arranged in a plurality of arrays (Mᵢ), each comprising a plurality of rows and a plurality of columns, wherein:
in each array (Mᵢ), the elementary cells (20) of a same row of the array share a same second conductive track (RWL) and a same third conductive track (WWL); and
the elementary cells (20) having the same coordinates in the different arrays (Mᵢ) share a same first conductive track (VBLT),
and wherein the different arrays (Mᵢ) are respectively formed in a plurality of stacked semiconductor levels of an integrated circuit.

2. The memory circuit of claim 1, wherein the first read and write access port (RWPT) of each elementary cell (20) further comprises a fourth transistor (T1) coupling the first storage node (BLTI) to a fourth conductive track (HBLT) of the cell and wherein, in each array (Mᵢ), the elementary cells (20) of a same column of the array share a same fourth conductive track (HBLT) .

3. The memory circuit of claim 1 or 2, wherein:
in each elementary cell (20), the storage cell (12) further comprises a second node (BLFI) for storing a data bit complementary to the bit stored on the first storage node (BLFI);
each elementary cell (20) comprises a second read access port (RPF) comprising a fifth transistor (T5) coupled by its gate to the second storage node (BLFI) of the cell, a sixth transistor (T6) series-assembled with the fifth transistor (T5) between the first node (GND) of application of a reference potential of the cell and a fifth conductive track (VBLF) of the cell;
each elementary cell (20) comprises a second read and write access port (RWPF) comprising a seventh transistor (T8) coupling the second storage node (BLFI) of the cell to the fifth conductive track (VBLF) of the cell, the gate of the sixth transistor (T6) being coupled to the second conductive track (RWL) of the cell and the gate of the seventh transistor (T8) being coupled to the third conductive track (WWL) of the cell; and
the elementary cells (20) having the same coordinates in the different arrays (Mᵢ) share a same fifth conductive track (VBLF) .

4. The memory circuit of claim 3, wherein the second read and write access port (RWPF) of each elementary cell (20) further comprises an eighth transistor (T4) coupling the second storage node (BLFI) of the cell to a sixth conductive track (HBLF) of the cell and wherein, in each array (Mᵢ), the elementary cells (20) of a same column of the array share a same sixth conductive track (HBLT).

5. The memory circuit of any of claims 1 to 4, wherein, in each elementary cell (20), the storage cell (12) comprises two inverters assembled in antiparallel.

6. The memory circuit of any of claims 1 to 5, wherein, in each array (Mᵢ), the elementary cells (20) of a same row have their first nodes (GND) connected to a same conductive track (VGND) of application of a reference potential, the elementary cells (20) of different rows having their first nodes (GND) connected to different conductive tracks (VGND) of application of a reference potential, and the elementary cells (20) of different arrays (Mᵢ) having their first nodes (GND) connected to different conductive tracks (VGND) of application of a reference potential.

7. The memory circuit of any of claims 1 to 6, further comprising, for each first conductive track (VBLT), an elementary precharge cell (50) comprising a transistor (T11) coupling the first conductive track (VBLT) to a node (VDD) of application of a high power supply potential of the circuit.

8. The memory circuit of any of claims 1 to 7, further comprising, for each first conductive track (VBLT), an elementary logic circuit (60) connected to the first conductive track (VBLT), the elementary logic circuit (60) being capable of implementing calculation operations having as operands data stored in the memory circuit.

9. The memory circuit of claim 8, wherein the elementary logic circuits (60) are formed in CMOS technology or in ReRAM technology.

10. The memory circuit of any of claims 1 to 9, further comprising a control circuit capable of simultaneously applying:
on the second conductive track (RWL) of a first row of a first array (Mᵢ) of the memory circuit, a signal for controlling to the on state the second transistors (T3) of the cells of the first row; and
on the third conductive track (WWL) of a second row of a second array (Mⱼ) of the memory circuit, the cells of the second row being connected to the same first conductive tracks (VBLT) as the cells of the first row, a signal for controlling to the on state the third transistors (T7) of the second row.
